# EUROPEAN PATENT APPLICATION

(11) **EP 2 475 012 A1**
(43) Date of publication of application: **11.07.2012**
(21) Application number: 10812039.5
(22) Date of filing: 30.08.2010
(51) Int. Cl.: H01L 31/042

(54) **SOLAR CELL MODULE**

(30) Priority: 31.08.2009 JP 2009200471
(71) Applicant: Sanyo Electric Co., Ltd., Osaka 570-8677 (JP)
(72) Inventor: NAKATANI Shihomi, Moriguchi-shi Osaka 570-8677 (JP); AOU Masayuki, Moriguchi-shi Osaka 570-8677 (JP)
(74) Representative: Glawe, Delfs, Moll
(86) International application number: PCT/JP2010/064679
(87) International publication number: WO 2011/024993

(57) **Abstract**

To prevent the power output wires from being misaligned during the laminating step and reduce moisture entry through the opening, for improved reliability and product yield of solar cell module. A solar cell module includes: a front-surface protection member 12; a rear-surface protection member 13; a plurality of solar cells 11 electrically connected by wiring members 16; a sealing member 14 for sealing the solar cells between the front-surface protection member 12 and the rear-surface protection member 13; and power output wires 20 for taking an output from the solar cells 11. The rear-surface protection member 13 has an opening 13a, and a sealing film 30 is disposed to cover the opening. The sealing film has a slit for insertion of the power output wires,and the power output wires 20 are routed out of the rear-surface protection member 13 through the opening 13a.

## Description

### [Technical Field]

The present invention relates to solar cell modules.

### [Background Art]

Generally, a single solar cell can supply an output of only a few watts. For this reason, when solar cell is utilized as a power source for a house, a building, etc., a plurality of solar cells are connected together in the form of a solar cell module for increased output. The solar cell module includes a plurality of solar cells each having a front and a rear surfaces provided with electrodes, via which they are connected in series and/or parallel by wiring members.

The solar cells which are mutually connected via the wiring members are placed between a transparent front-surface protection member and a rear-surface protection member, being sealed in a encapsulant composed mainly of ethylene vinyl acetate copolymer (EVA) for example, for increased resistance to weathering and impacts so that practical tapping of electrical power can be possible in outdoor environment.

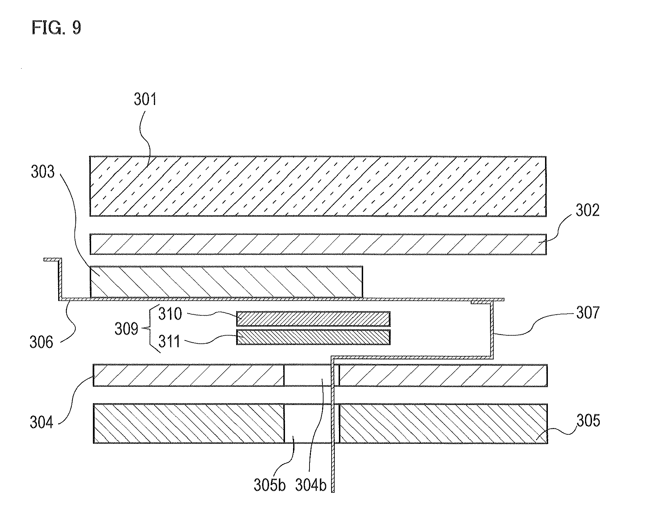

Fig. 9 is a schematic sectional view of a conventional solar cell module. This solar cell module includes a transparent front-surface protection member 301 made of glass for example; solar cells 303; transparent sealing members 302, 304; and a rear-surface protection member 305.

In this solar cell module, each of the solar cells 303 has electrodes on their front and rear surfaces. These solar cells are connected together by inner lead wires 306, sandwiched between the front-surface protection member 301 and the rear-surface protection member 305, and sealed by the transparent sealing members 302, 304.

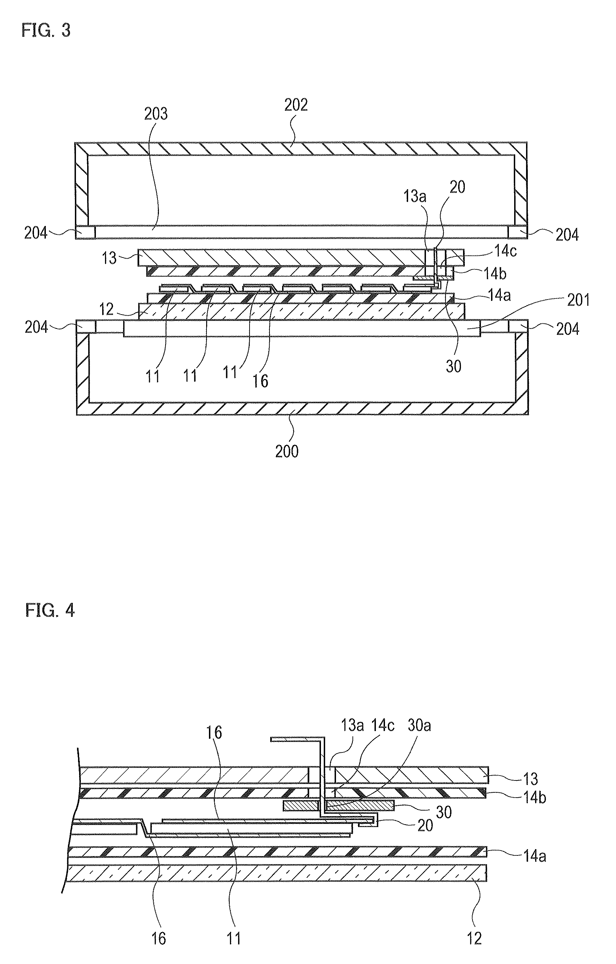

Since the output from the solar cells must be taken out of the solar cell module, openings 305b, 304b are provided as shown in Fig. 9, in the rear-surface protection member 305 and in the rear-surface-side sealing member 304 respectively. From these openings 305b, 304b, power output wires (lead-out electrodes) 307 which are connected to the solar cells 303 are routed out to the outside. Although not illustrated, a terminal box is attached to the opening 305b, so that the power output wires 307 from the opening 305b can be connected to terminals provided inside the terminal box for further connection to an external circuit (see Patent Literature 1, Fig. 4, for example).

In a solar cell module disclosed in the Patent Literature 1, the rear-surface-side sealing member 304 and the rear-surface protection member 305 are respectively provided with the openings 304b, 305b which have a size, for example, of 40 mm x 70 mm in order to expose ends of the power output wires 307. In addition, a sealing member 309 is disposed between the solar cell 303 and the power output wires 307. The sealing member 309 is a laminated body which is composed of a bonding member 310 and a moistureproof member 311, made sufficiently larger than the openings 304b, 305b in the rear-surface-side sealing member 304 and the rear-surface protection member 305, and disposed between the power output wires 307 and the solar cell 303.

After all of these components have been disposed and stacked as described above, the solar cell module is placed in a laminator, so that the entire assembly is pressed together into an integrated body under a heat and a partial vacuum. The integration process leaves end portions of the power output wires 307 exposed in the openings 304b, 305b in the rear-surface-side sealing member 304 and the rear-surface protection member 305. Therefore, the end portions of the power output wires 307 may be bent out when it is necessary, whereby the power output wires 307 can be led out of the openings 304b, 305b very easily as shown in Fig. 9.

Further, since the openings 304b, 305b are sealed by the sealing member 309 provided by a laminated body composed of the bonding member 310 and the moistureproof member 311, moisture for example, is prevented from passing through the openings into the solar cell module and degrading power output capability of the solar cell module. Therefore a good level of reliability is maintained.

### [Citation List]

### [patent Literature]

[Patent Literature 1] JP-A 2004-356349 Gazette (Fig. 4)

### Summary of Invention

### [Technical Problem]

In the above-mentioned Patent Literature 1, the power output wires 307 are first inserted into the openings 304b, 305b, and then the sealing member 309 is placed on the the openings 304b, 305b. Thus, this procedure permits a partly free movement in the the openings 304b, 305b to the power output wires 307. If the entire assembly is integrated by a laminator under this state, the power output wires 307 is misaligned during the laminating step.

The power output wires 307 are connected to the terminals in the terminal box. However, when the power output wires 307 are misaligned, the spacing between the power output wires 307, and the length of the the power output wires, for exmple, are also changed. Because this results in a disconnection to the terminals in the terminal box, an inferior solar cell module is produced and a product yield declines, for example.

It is an object of the present invention to prevent the power output wires from being misaligned during the laminating step and reduce adverse affect of moisture entry through the opening, for improved reliability and product yield of the solar cell module.

### [Solution to Problem]

The present invention provides a solar cell module which includes: a front-surface protection member; a rear-surface protection member; a plurality of solar cells electrically connected by wiring members and disposed between the front-surface protection member and the rear-surface protection member; a sealing member for sealing the solar cells between the front-surface protection member and the rear-surface protection member; and output wires for taking an output from the solar cells. With the arrangement described above, the rear-surface protection member has an opening, and a sealing film is disposed in a manner to cover the opening. The sealing film has a slit for insertion of the power output wires, and the power output wires are routed out of the rear-surface protection member through the slit in the sealing film and the opening.

Also, a terminal box may be attached to the rear-surface protection member to cover the opening in the rear-surface protection member.

### [Advantageous Effects of Invention]

According to the present invention, as the power output wires are inserted into the slit in the sealing film, the spacing, the length by which the wire can be pulled out, etc. of the power output wires are determined. Additionally, this makes it possible to prevent the power output wires from being misaligned during the laminating step. A sealing film is disposed in a manner to cover the opening, and therefore moisture entry through the opening can be reduced.

### Brief Description of the Drawings

Fig. 1 is a schematic sectional view of a solar cell module according to an embodiment of the present invention.
Fig. 2 is a schematic sectional view showing a configuration of a solar cell utilized in the present invention.
Fig. 3 is a schematic diagram of a manufacturing apparatus for manufacture of a solar cell module.
Fig. 4 is a fragmentary sectional view showing a power output wire lead-out region in the embodiment of the present invention before a laminating step.
Fig. 5 is a fragmentary sectional view showing a power output wire lead-out region in the embodiment of the present invention after the laminating step.
Fig. 6 is a fragmentary sectional view showing a power output wire lead-out region of another embodiment of the present invention after the laminating step.
Fig. 7 is a plan view showing an opening in the solar cell module according the embodiment of the present invention.
Fig. 8 is a plan view when a power output wire region in a solar cell module according to the embodiment of the present invention is viewed from rear.
Fig. 9 is a schematic sectional view of a conventional solar cell module.

### Description of Embodiments

Embodiments of the present invention will be described in detail with reference to the drawings. It should be noted here that throughout the drawings the same or equivalent parts and components will be indicated with the same reference symbols, and their description will not be repeated in order to avoid redundancy in description. It should also be noted that all the drawings are of a conceptual nature and may not reflect actual dimensional proportions, etc. Therefore, information about specific dimensions, etc. should be understood and determined from the description to be given hereafter. Kneep in mind that proportional and other relationships may also differ from one drawing to another.

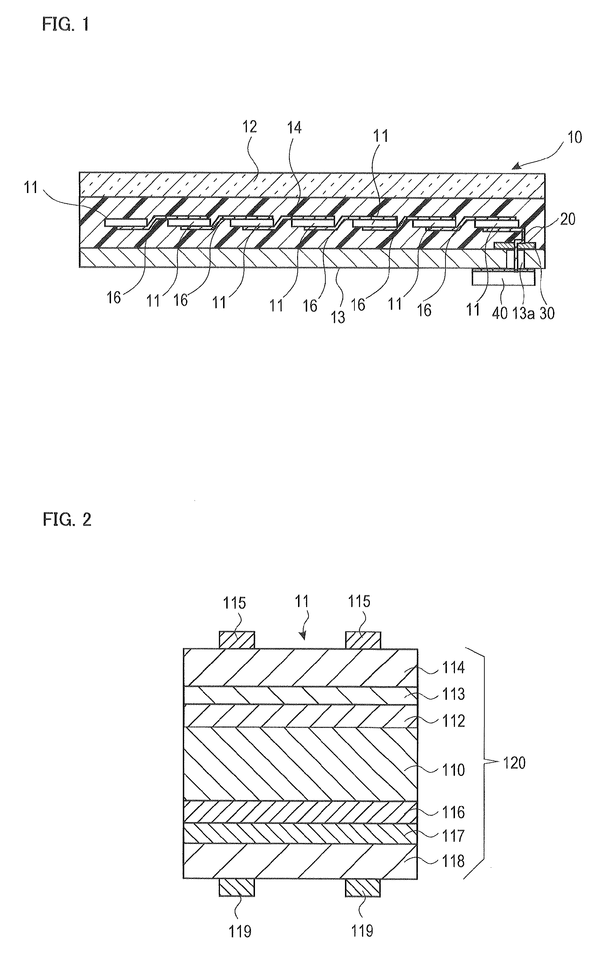

Now, reference will be made to Fig. 1 to describe general configuration of a solar cell module 10 according to an embodiment of the present invention. Fig. 1 is an enlarged side view showing a section of the solar cell module 10 according to the present embodiment.

The solar cell module 10 includes solar cells 11, a front-surface protection member 12, a rear-surface protection member 13 and a sealing member 14. The solar cell module 10 is made by sealing a plurality of the solar cells 11 between the front-surface protection member 12 and the rear-surface protection member 13.

The solar cells 11 are connected with each other by wiring members 16. The connection between the solar cell 11 and the wiring member 16 is achieved by solder or resin adhesive.

Each solar cell 11 has a light receiving surface for solar incident, and a rear surface facing away from the light receiving surface. Each solar cell 11 has electrodes formed on its light receiving surface and its rear surface. The solar cell 11 has a configuration, which will be described later in more detail.

The wiring member 16 is connected to the electrode on the light receiving surface of one solar cell 11 and to the electrode on the rear surface of another solar cell 11 which is adjacent thereto. Thus, electrical connection is established between mutually adjacent solar cells 11, 11. The wiring member 16 is a thin platy piece of copper foil having its surfaces plated with solder.

If the wiring member 16 and the solar cell 11 are connected to each other with solder, the solder which is plated on the wiring member 16 is caused to melt to connect to the electrode on the solar cell 11.

If resin adhesive is used, a resin adhesive is applied between the wiring member 16 and the solar cell 11, so that the solar cell 11 and the wiring member 16 are connected to each other via the resin adhesive. It is preferable that the resin adhesive sets at temperatures not higher than the melting temperature of eutectic solder, i.e., approximately 200°C. The resin adhesive may be provided by an electrically conductive adhesive film for example. The electrically conductive adhesive film should at least contain a resin adhesive component and electrically conductive particles dispersed therein. This resin adhesive component containing the above-mentioned electrically conductive particles therein is provided on a backing film of polyimide for example. The resin adhesive component is a composition containing a thermosetting resin, and may be provided by epoxy resin, phenoxy resin, acrylic resin, polyimide resin, polyamide resin or polycarbonate resin. Only one kind may be selected from these thermosetting resins, or a combination of two or more kinds may be used. Preferably, one or more thermosetting resins selected from a group consisting of epoxy resin, phenoxy resin and acrylic resin should be utilized.

The electrically conductive particles may be provided by particles of a metal such as gold, silver, copper and nickel, or particles of an electrically conductive or insulating material having their surfaces coated with an electrically conductive layer of gold, copper, nickel or others.

The front-surface protection member 12 is disposed on the light receiving surface side of the sealing member 14 and protects the surface of the solar cell module 10. The front-surface protection member 12 may be provided by water-shielding transparent glass, transparent plastic, etc.

The rear-surface protection member 13 is disposed on the rear surface side of the sealing member 14 and protects the rear surface of the solar cell module 10. The rear-surface protection member 13 may be provided by a film of a resin such as PET (Polyethylene Terephthalate), or a laminated film made by sandwiching a foil of Al between resin films. In the present embodiment shown in Fig. 1, the rear-surface protection member 13 is provided by a resin film of PET for example.

The sealing member 14 seals the solar cells 11 between the front-surface protection member 12 and the rear-surface protection member 13. The sealing member 14 may be provided by a transparent resin such as EVA, EEA, PVB, silicone, urethane, acrylic and epoxy. In the present embodiment, an EVA resin is utilized.

It should be noted here that the solar cell module 10 configured as the above may have an Al (aluminum) frame (unillustrated) attached therearound.

The wiring members 16 are connected to power output wires 20 for taking the solar cells' output to the outside of the module. The power output wires 20 serve as a route to carry the electrical output from the solar cells 11 to terminals in a terminal box 40, and are normally provided by a piece obtained by solder-plating an entire surface of a copper foil which has a thickness of approximately 0.1 mm through 0.3 mm and a width of 6 mm and cutting this foil into a predetermined length. The wire thus obtained is soldered to the wiring member 16. The power output wire 20 has its surfaces coated with an insulating film.

The rear-surface protection member 13 has an opening 13a for the power output wires 20 to come out. As will be described later also, the sealing member 14 on the rear surface side has an opening for the power output wires 20 to come out, too. These openings are rectangular, having a size of 40 mm x 70 mm for example.

The present embodiment includes a sealing film 30 which is sufficiently larger than these openings. As will be described later, this sealing film 30 has a slit for the power output wires 20 to be inserted therethrough. This slit is only slightly wider than the thickness of the power output wires 20, and is long enough for insertion of a plurality of the power output wires 20 without overlapping each other. As the power output wires 20 are inserted into the slit in the sealing film 30, the spacing, the length by which the wire can be pulled out, etc. of the power output wires 20 are determined accordingly.

The sealing film 30 disposed to cover the opening 13a sets the power output wires 20 to come out of the rear-surface protection member 13 in the solar cell module 10 by predetermined length and spacing.

The terminal box 40 is attached using a silicone resin for example, to cover the opening 13a in the rear-surface protection member 13. The power output wires 20 coming out of the opening 13a are then connected to the terminals in the terminal box 40 for connection to an external circuit.

Next, a configuration of the solar cells 11 will be described.
The solar cell 11 has a photoelectric conversion unit and electrodes. The electrodes are, for example, finger electrodes and bus bar electrodes.

The photoelectric conversion unit produces carriers as it receives sunlight. In this Description, the term carriers refers to holes and electrons produced by the sunlight as it is absorbed in the photoelectric conversion unit. The photoelectric conversion unit has an n-type region and a p-type region therein, with a semiconductor junction formed in the interface between the n-type region and the p-type region. The photoelectric conversion unit may be formed from a semiconductor substrate of a crystalline semiconductor material such as monocrystal Si and polycrystal Si; a semiconductor compound such as GaAs and InP; etc. The photoelectric conversion unit in the solar cell utilizes an arrangement, for example, where an intrinsic amorphous silicon layer is placed between a monocrystal silicon layer and an amorphous silicon layer of mutually opposing conductivity types for reduced defect in the interface and improved characteristic of hetero junction interface.

The finger electrodes collect carriers from the photoelectric conversion unit. The finger electrodes are formed to cover substantially all of the light receiving surface in the photoelectric conversion unit. The finger electrodes may be formed by using an electrically conductive resin paste made of a resin material as a binder and electrically conductive particles of e.g. silver as a filler. It should be noted here that the finger electrodes are formed both on the light receiving surface and on the rear surface of the photoelectric conversion unit alike.

The bus bar electrodes collect carriers from the finger electrodes. The bus bar electrodes are formed to cross the finger electrodes. The bus bar electrode may be formed by substantially the same method as for the finger electrodes, by using an electrically conductive resin paste made of a resin material as a binder and electrically conductive particles of e.g. silver as a filler.

The quantity of the bus bar electrodes may be determined in consideration of the size of the photoelectric conversion unit for example.

Next, as a specific configuration example of the solar cell 10, description will cover a case where the photoelectric conversion unit has a structure called Heterojunction with Intrinsic Thin-layer, with a reference to Fig. 2. Fig. 2 is a schematic unital view showing the configuration of the solar cell.

As shown in Fig. 2, a photoelectric conversion unit 120 includes a transparent conductive layer 114, a p-type amorphous silicon layer 113, an i-type amorphous silicon layer 112, an n-type monocrystal silicon substrate 110, an i-type amorphous silicon layer 116, an n-type amorphous silicon layer 117 and a transparent conductive layer 118.

The n-type monocrystal silicon substrate 110 has its light receiving surface side formed with the p-type amorphous silicon layer 113 via the i-type amorphous silicon layer 112. The p-type amorphous silicon layer 113 has its light receiving surface side formed with the transparent conductive layer 114. On the other hand, the n-type monocrystal silicon substrate 110 has its rear surface side formed with the n-type amorphous silicon layer 117 via the i-type amorphous silicon layer 116. The n-type amorphous silicon layer 117 has its rear surface side formed with the transparent conductive layer 118.

Electrodes 115, 119 including finger electrodes and the bus bar electrodes, are formed on the light receiving surface side of the transparent conductive layer 114 and on the rear surface side of the transparent conductive layer 118 respectively.

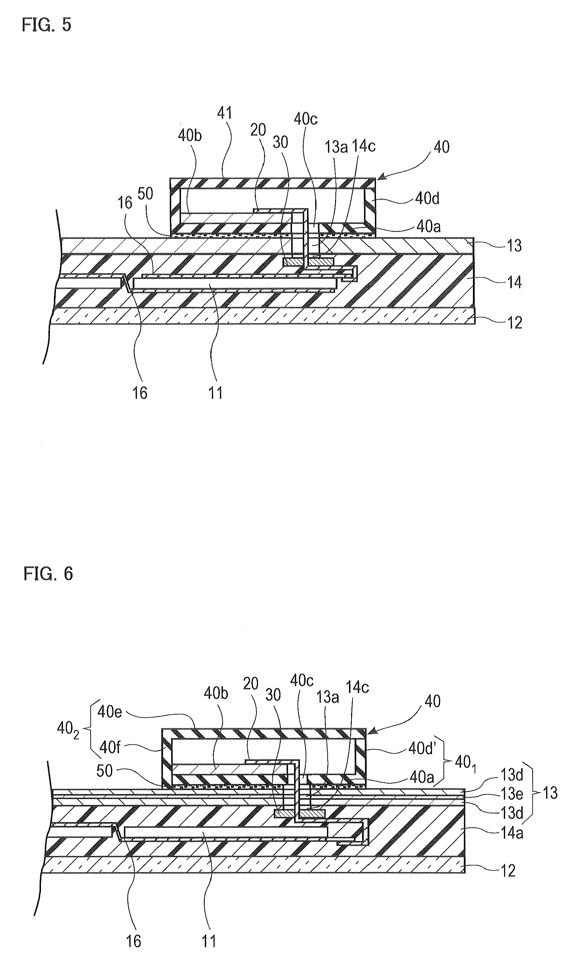

Hereinafter, reference will be made to Fig. 4 and Fig. 5 to describe how the power output wires 20 may be brought out of the solar cell module. Fig. 4 is a fragmentary sectional view showing a power output wire lead-out region of the present embodiment before a laminating step whereas Fig. 5 shows the power output wire lead-out region of the present embodiment after the laminating step.

As shown in Fig. 4 and Fig. 5, openings 14c, 13a are made in the rear surface side sealing member 14b and the rear-surface protection member 13 respectively. These openings 14c, 13a are completely covered by the sealing film 30 which has the slit 30a for insertion of the power output wires 20 and is disposed between the rear surface side sealing member 14b and a solar cell 11. The sealing film 30 is a film of a resin such as PET and PVF.

The power output wires 20 are inserted through the slit 30a of the sealing film 30. The sealing film 30 is disposed between the rear-surface protection member 13 and the solar cell 11. This slit 30a is only slightly wider than the thickness of the power output wires 20, and is long enough for insertion of a plurality of the power output wires 20 side by side. As the power output wires 20 are inserted into the slit 30a in the sealing film 30, each power output wires 20 are tentatively fixed by the slit 30a, and then the spacing, the length by which each wire can be pulled out respectively, etc. of the power output wires are determined accordingly.

The sealing film 30 disposed to cover the openings 13a, 14c, sets the power output wires 20 to come out of the rear-surface protection member 13 in the solar cell module 10 by predetermined length and spacing.

The sealing film 30 is first tentatively fixed so as to cover the opening 14c in the rear surface side sealing member 14b, and then the power output wires 20 are inserted through the slit 30a. This procedure prevents undesirable movement of the sealing film 30 during a step of modularization, resulting in improved assemblability.

After the laminating step, the sealing film 30 is at the openings 13a, 14c as shown in Fig. 5. The sealing film 30 is introduced also into these openings 13a, 14c, establishing water-tight sealing to the openings 13a, 14c. Then, the terminal box 40 has its bottom 40a bonded around the opening 13a in the rear-surface protection member 13 using a silicone resin 50 for example. The bottom 40a of the terminal box 40 has an opening 40c for insertion of the power output wires 20. This opening 40c is smaller than the openings 13a, 14c. Also, the bottom 40a is larger than the opening 13a, 14c so as to provide complete coverage over the openings 13a, 14c. Specifically, the openings 13a, 14c are larger than the opening 40c of the terminal box 40, and smaller than the terminal box 40.

The power output wires 20 coming out of the openings 13a, 14c and the opening 40c are then connected to terminals on a terminal block 40b inside the terminal box 40. Thereafter, the terminal box 40 is sealed closely by an upper lid 41 attached to a body 40c which is a continuous part from the bottom 40a, whereby the solar cell module 10 is complete.

Next, a method of manufacturing the solar cell module 10 will be described with reference to Fig. 3. Fig. 3 is a schematic diagram of a manufacturing apparatus for manufacture of the solar cell module 10. The apparatus includes a lower housing 200 and an upper housing 202 to be coupled with the lower housing in an airtight state. The lower housing 200 has an upper opening, where a heater plate 201 is disposed substantially flush therewith. The upper housing 202 is provided with a rubber diaphragm 203 on a side opposed to the opening in the lower housing 200. The lower housing 200 and the upper housing 202 are provided with packings 204 entirely along their respective surrounding edges to maintain an air-tight state when the two housings are coupled together.

Further, though not illustrated, a vacuum pump is connected to the lower housing 200.

When manufacturing the solar cell module 10, first, the following components are placed on the heater plate 201 of the apparatus one after another in the order of listing: an front-surface protection member 12; a front surface side EVA sheet 14a (sealing member) ; a plurality of solar cells 11...which are connected to each other with wiring members 16; a sealing film 30 at a place corresponding to an opening 14c in an EVA sheet 14b; the EVA sheet 14b (sealing member); and a rear-surface protection member 13. Power output wires 20 are inserted through the slit 30a in the sealing film 30, each of the power output wires 20 being tentatively held at its predetermined position.

After all of the above-mentioned components are laminated on the heater plate 201, the lower housing 200 and the upper housing 202 are coupled with each other. Thereafter, air in the lower housing 200 is removed by the unillustrated vacuum pump. During this process, the heater plate 201 is brought to a temperature range of approximately 130°C through 200°C. Under this state, the diaphragm 203 is pressed down toward the solar cell module 10 which is placed on the heater plate 201. The EVA sheets 14a, 14b gelate to become a predetermined EVA layer (sealing layer) 14. Through this process, the solar cells 11 ..., which are already sandwiched between the front-surface protection member 12 on the front surface side and the rear-surface protection member 13 on the rear surface side, are sealed into the EVA layer (sealing layer) 14. Meanwhile, the sealing film 30 flows into and fills the opening 14c in the EVA sheet 14b integrally therewith, thereby closing the opening 14c.

Thereafter, a terminal box 40 is attached to the rear-surface protection member 13 with a silicone resin 50, to close the opening 13a in the rear-surface protection member 13.

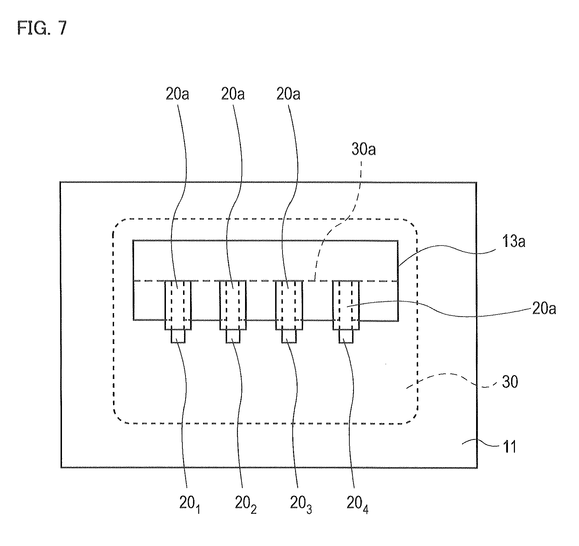

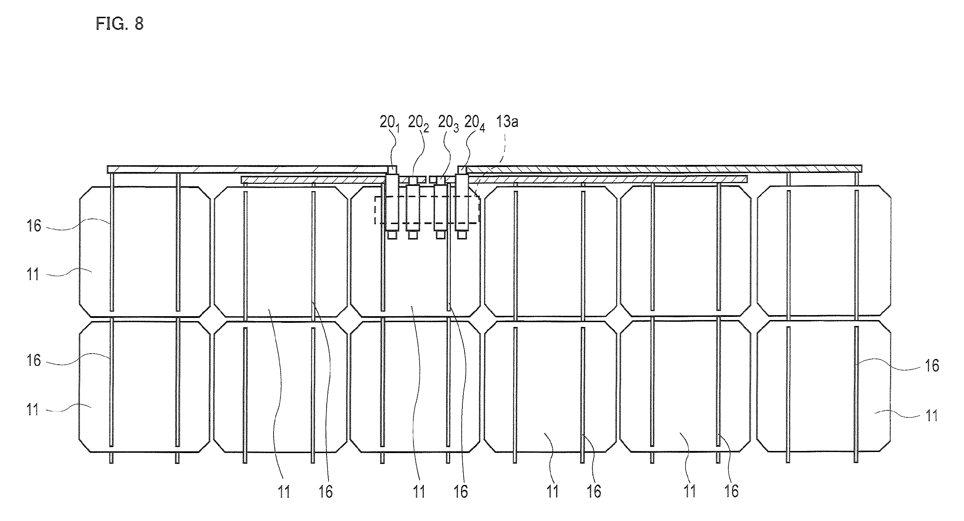

Fig. 7 is a plan view showing the power output wires and the opening in the solar cell module according to the present embodiment whereas Fig. 8 is a plan view when power output wires 20₁ through 20₄ in the solar cell module according to the present embodiment is viewed from the rear surface side.

As shown in Fig. 7, in the embodiment according to the present invention, the place where the rear-surface protection member 13 has the opening 13a is the place where the sealing film 30 is disposed. Thus, the sealing film 30 reduces moisture entering from the opening 13a.

In the present embodiment, a total of four power output wires are routed of the opening 13a through the slit 30a in the sealing film 30. Accordingly, the terminal block of the terminal box 40 is provided with four terminals, for connection of power output wires 20₁ through 20₄. Each of the terminals in the terminal box 40 is connected to a back current preventing diode. Each of these power output wires 20₁ through 20₄ is insulated from the other power output wires by an insulation film 20a. In the present embodiment, the power output wires 20₁, 20₄ are connected respectively to a positive terminal and a negative terminal for connection to external lead wires. The power output wires 20₂, 20₃ constitute so called transition wiring between solar cell strings, with part of the wires being routed to the terminals in the terminal box 40.

In Fig. 8, a total of six solar cell strings are connected in series. The leftmost solar cell string has the power output wire 20₁, which comes out of the slit 30a in the sealing film 30, and is connected to the positive or negative terminal in the terminal box 40 for connection to an external lead wire. The second and the third solar cell strings from the left are connected to each other with a transition output wire 20₂. This output wire 20₂ comes out of the slit 30a in the sealing film 30, and is connected to the terminal in the terminal box 40. The second and the third solar cell strings from the right are connected to each other with a transition output wire 20₃. This output wire 20₃ comes out of the slit 30a in the sealing film 30, and is connected to the terminal in the terminal box 40. The rightmost solar cell string has the power output wire 20₄, which comes out of the slit 30a in the sealing film 30, and is connected to the negative or positive terminal in the terminal box 40 for connection to the external lead wire.

As has been described, the power output wires 20₁ through 20₄ are started from six solar cell strings, then routed through the opening 13a in the rear-surface protection member 13, and then connected to predetermined terminals in the terminal box 40, to constitute a solar cell module.

Fig. 6 is a schematic sectional view according to another embodiment.

This embodiment shown in Fig. 6 makes use of a laminated film of an Al foil 13e sandwiched between PET resin films 13d, 13d for further reduction in the amount of moisture passing through the rear-surface protection member 13. When such a laminated film is used, the rear-surface protection member 13 has a large opening 13a so that the power output wires 20 will not make contact. Here again, this opening 13a is made to face a surface of one solar cell 11. Since the opening 13a is covered by the sealing film 30, the sealing film 30 is present under the opening 13a, preventing moisture from entering. With the above, a slit 30a is made along the centerline of the opening 13a for insertion of the power output wires 20. As a result, the power output wires 20 are guided by the slit 30a, reliably separated from edges of the opening 13a, being insulated from the Al foil 13e in the rear-surface protection member 13, eliminating a risk of an electric current flowing through the Al foil 13e.

With the above-described arrangement, the bottom 40a of the terminal box 40 is bonded around the opening 13a in the rear-surface protection member 13 using a silicone resin 50 for example. The bottom 40a of the terminal box 40 has an opening 40c for insertion of the power output wires 20. This opening 40c is smaller than the openings 13a, 14c. Also, the bottom 40a is larger than the opening 13a, 14c so as to provide complete coverage over the openings 13a, 14c. Specifically, the openings 13a, 14c are larger than the opening 40c of the terminal box 40, and smaller than the terminal box 40. As another difference, the terminal box 40 shown in Fig. 5 is formed as a box, i.e., composed of a bottom 40a, a body 40d and an upper lid 41. On the other hand, the terminal box 40 shown in Fig. 16 is composed of a main body 40₁ which includes the bottom 40a and a side wall 40d' ; and a lid 40₂ which includes an upper portion 40e and a side wall 40f.

The power output wires 20 coming out of the openings 13a, 14c and the opening 40c are then connected to terminals on a terminal block 40b inside the terminal box 40. Thereafter, though not illustrated, the lid 40₂ of the terminal box 40 is sealingly attached to the main body 40₂, whereby the solar cell module 10 is complete.

Also, the sealing film 30 described thus far may be provided by a laminated film of a resin layer and a bonding member layer. In this case, the rear surface side sealing member 14b is disposed between the sealing film 30 and the solar cell 11.

The present invention is also applicable to thin film solar cell modules which use thin films of silicon and compound semiconductors.

All of the embodiments disclosed herein are to show examples, and should not be considered as of a limiting nature in any way. The scope of the present invention is identified by the claims and is not by the descriptions of the embodiments given hereabove, and it is intended that the scope includes all changes falling within equivalents in the meaning and extent of the Claims.

### [Reference Signs List]

- 10: solar cell module
- 11: solar cell
- 12: front-surface protection member
- 13: rear-surface protection member
- 13a: opening
- 14: sealing member
- 16: wiring member
- 30: sealing film
- 30a: slit

## Claims

1. A solar cell module comprising: an front-surface protection member; a rear-surface protection member; a plurality of solar cells electrically connected by wiring members and disposed between the front-surface protection member and the rear-surface protection member; a sealing member for sealing the solar cells between the front-surface protection member and the rear-surface protection member; and output wires for taking an output from the solar cells;
wherein the rear-surface protection member has an opening, a sealing film is disposed in a manner to cover the opening, and the sealing film has a slit for insertion of the power output wires, and the power output wires are routed out of the rear-surface protection member, through the slit in the sealing film and the opening.

2. The solar cell module according to Claim 1, wherein the slit is slightly wider than the thickness of the power output wires, and long enough for insertion of a plurality of the power output wires without overlapping each other.

3. The solar cell module according to Claim 1 or 2, further comprising a terminal box attached to the rear-surface protection member, covering the opening in the rear-surface protection member.

4. The solar cell module according to Claim 3, wherein the terminal box includes a bottom attached to the the rear-surface protection member, the bottom having an opening for insertion of the power output wires.

5. The solar cell module according to Claim 5, wherein the rear-surface protection member is larger than the opening in the terminal box, and smaller than the bottom of the terminal box.
